# EUROPEAN PATENT SPECIFICATION

(11) **EP 4 348 350 B1**
(45) Date of publication and mention of the grant of the patent: **01.10.2025**
(21) Application number: 22723689.0
(22) Date of filing: 22.04.2022
(51) Int. Cl.: G03F 7/004

(54) **HYBRID PHOTORESIST COMPOSITION FOR EXTREME ULTRAVIOLET PHOTOLITHOGRAPHY APPLICATIONS**
HYBRIDE PHOTORESISTZUSAMMENSETZUNG FÜR EXTREM ULTRAVIOLETTE PHOTOLITHOGRAFIEANWENDUNGEN
COMPOSITION DE RÉSINE PHOTOSENSIBLE HYBRIDE POUR LES APPLICATIONS DE PHOTOLITHOGRAPHIE DANS L'ULTRAVIOLET EXTRÊME

(30) Priority: 28.05.2021 EP 21176454
(43) Date of publication of application: 10.04.2024
(73) Proprietor: ASML Netherlands B.V., 5500 AH Veldhoven (NL)
(72) Inventor: BROUWER, Albert, Manfred, 1012 WX Amsterdam (NL); EVRARD, Quentin, Jack, Omer, 3526 KV Utrecht (NL); GOYA, Tsuyoshi, Osaka, Osaka 564-0034 (JP); SUGIOKA, Takuo, Osaka, Osaka 564-0034 (JP)
(74) Representative: ASML Netherlands B.V.
(86) International application number: PCT/EP2022/060688
(87) International publication number: WO 2022/248129

(56) References cited:
- WO-A1-2021/011367
- US-A1- 2015 056 542
- US-A1- 2020 241 413
- CARDINEAU BRIAN ET AL: "Photolithographic properties of tin-oxo clusters using extreme ultraviolet light (13.5nm)", MICROELECTRONIC ENGINEERING, vol. 127, 24 April 2014 (2014-04-24), pages 44 - 50, XP028868137, ISSN: 0167-9317, DOI: 10.1016/J.MEE.2014.04.024
- NAJMEH SADEGH ET AL: "XUV Induced Bleaching of a Tin Oxo Cage Photoresist Studied by High Harmonic Absorption Spectroscopy", ARXIV.ORG, CORNELL UNIVERSITY LIBRARY, 201 OLIN LIBRARY CORNELL UNIVERSITY ITHACA, NY 14853, 24 March 2020 (2020-03-24), XP081628176

## Description

### CROSS-REFERENCE TO RELATED APPLICATIONS

This application claims priority of EP/US application 21176454.3 which was filed on May 28, 2021

### FIELD

The present invention relates to resist compositions for use in lithography, particularly in the fabrication of integrated circuits, the use of alkyltin-oxo cage cations having large non-nucleophilic counterions, a substrate comprising at least one surface coated with a composition comprising an alkyltin-oxo cage cation having large non-nucleophilic counterions, and a method of producing a semiconductor using such resist compositions. In particular, the present invention relates to resist compositions for use in EUV lithography. The large non-nucleophilic counterions include tetrakis(pentafluorophenyl) borate, tetrakis[3,5-bis(trifluoromethyl)phenyl]borate, tetrakis[3,5-bis(tert-butyl)phenyl]borate, and tetrakis[(3,5-bis(1,1,1,3,3,3-hexafluoro-2-methoxypropan-2-yl)phenyl)phenyl]borate.

### BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

Known resists suitable for use with lithography are referred to as chemically amplified resists (CAR) and are based on polymers. Upon expose to electromagnetic radiation or an electron beam, the polymers in the CAR absorb photons or interact with electrons, and secondary electrons are generated. The generation of secondary electrons is how a high-energy photon or electron loses most of its energy. The secondary electrons in the resist diffuse and may generate further secondary electrons with lower energies until the energy of the secondary electrons is lower than that required to break bonds in the CAR or to result in ionisation. The electrons generated excite photo-acid generators (PAG) which subsequently decompose and can catalyse a deblocking reaction, which leads to a change in the solubility of the CAR.

Alternative resist systems for use with lithography, in particular EUV lithography, comprising metal oxide nanoclusters have been investigated to try to address the issues with CARs. These alternative resist systems comprise metal oxide nanoparticles or nanoclusters which are prevented from clustering together by a ligand shell. Upon EUV exposure, photons are absorbed by the nanoparticles or nanoclusters and this leads to the generation of secondary electrons. The electrons break the bonds between the ligands and the nanoparticles or nanoclusters. This allows the nanoparticles or nanoclusters to cluster together and hence changes the solubility of the resist. The metal oxide nanoparticles have larger EUV absorption cross-sections than carbon atoms in CAR and thus there is a greater likelihood of EUV photons being absorbed. Therefore, a less intense beam requiring less power or a shorter exposure to the EUV photons is required. Furthermore, the different conversion mechanism has potentially lower chemical noise than CAR resist systems. As described in Cardineau, B et al, Photolithographic properties of tin-oxo clusters using extreme ultraviolet light (13.5nm), Microelectronic Engineering 127 (2014), pp. 44-50 and Haitjema. J., et al, Extreme ultraviolet patterning of tin-oxo cages, Journal of Micro/Nanolithography, MEMS, and MOEMS, 16(3), 033510 (2017), doi: 10.1117/1.JMM.16.3.033510, tin-oxo cage materials have been investigated for use as photoresists for EUV lithography. The tin-oxo cage materials turn insoluble upon EUV irradiation and therefore act as negative tone resists.

It is desirable to provide resist compositions which achieve acceptable resolution, acceptable line-edge roughness and which have acceptable sensitivity. CARs have an intrinsically stochastic nature and therefore do not provide the highest resolution. Resists comprising metal atoms are negative tone materials with only moderate sensitivity

It is an objection of the present invention to address or overcome the disadvantages of existing resist compositions and to provide alternative resist compositions.

Whilst the present application generally refers to EUV lithography throughout, the invention is not limited to solely EUV lithography and it is appreciated that the subject matter of the present invention may be used in resists for photolithography using electromagnetic radiation with a frequency above or below that of EUV, or in any other type of lithography, such as electron beam lithography.

### SUMMARY

According to a first aspect of the present invention, there is provided a resist composition for use in the fabrication of integrated circuits, wherein the resist composition comprises an alkyltin-oxo cage having a counterion selected from tetrakis(pentafluorophenyl) borate, tetrakis[3,5-bis(trifluoromethyl)phenyl]borate, tetrakis[3,5-bis(tert-butyl)phenyl]borate, and tetrakis[(3,5-bis(1,1,1,3,3,3-hexafluoro-2-methoxypropan-2-yl)phenyl)phenyl]borate.

As such, the composition comprises an alkyltin-oxo cage cation having tetrakis (pentafluorophenyl)borate counterions, tetrakis[3,5-bis(trifluoromethyl)phenyl]boratecounterions, tetrakis[3,5-bis(tert-butyl)phenyl]borate counterions, or
tetrakis[(3,5-bis(1,1,1,3,3,3-hexafluoro-2-methoxypropan-2-yl)phenyl)phenyl]borate counterions.

As such, the composition may comprise an alkyltin-oxo cage having a counterion (anion) selected from one of the following:

i) B(C₆F₅)₄;

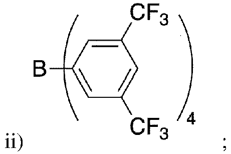

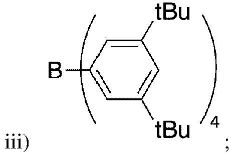

and

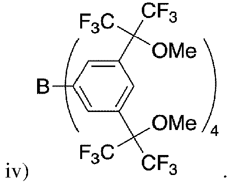

It has been found that large, non-nucleophilic counterions, such as tetrakis(pentafluorophenyl) borate counterions, cause the resist composition to work as a positive tone resist. It has also been found that such resist compositions have high sensitivity. When other counterions, such as hydroxide ions, are present, the material acts as a negative tone resist. Whilst the mechanism of action is still unknown, particularly as regards why the presence of the large, non-nucleophilic counterions, such as tetrakis(pentafluorophenyl) borate counterions, results in a positive tone resist whereas other resist compositions including alkyltin-oxo cage cations are negative tone resists, without wishing to be bound to any scientific theory, whilst the volume fraction of tin in a film formed from the compounds of the present invention is lower than in films formed from compounds having simple anions, such as hydroxide ions, it is believed that the overall EUV cross section is not substantially reduced as a result of the presence of fluorine atoms which have high EUV absorbance. As such, the resist is sensitive due to the high EUV absorbance provided by the fluorine atoms. In addition, having large groups included in the borate counterions may also provide sensitivity.

The alkyltin-oxo cage cation may have the formula [(BuSn)₁₂O₁₄(OH)₆]²⁺. As such, the resist compositions may include two of the anionic counterions described herein.

The resist composition may be a positive tone resist.

The resist composition may comprise a solvent. The solvent may be an alcohol or a fluorinated alkane. For example, the solvent may be butan-1-ol or may be fluorobenzene.

According to a second aspect of the present invention, there is provided the use of an alkyltin-oxo cage having a counterion selected from the group consisting of: tetrakis(pentafluorophenyl) borate, tetrakis[3,5-bis(trifluoromethyl)phenyl]borate, tetrakis[3,5-bis(tert-butyl)phenyl]borate, and tetrakis tetrakis[(3,5-bis(1,1,1,3,3,3-hexafluoro-2-methoxypropan-2-yl)phenyl)phenyl]borate, preferably an n-butyltin-oxo cage, in a resist composition.

The n-butyltin-oxo cage cation may have the formula [(BuSn)₁₂O₁₄(OH)₆]²⁺.

The use may be as a positive tone resist.

Metal-based EUV photoresists to date have been negative tone resists. The present invention provides an alternative to CARs with the additional benefits of a higher absorption cross section. Unexpectedly, the presence of one of the anions described herein provides positive tone functionality to the resist composition.

According to a third aspect of the present invention, there is provided a substrate comprising at least one surface coated with a composition comprising an alkyltin-oxo cage having a counterion selected from the group consisting of: tetrakis(pentafluorophenyl) borate, tetrakis[3,5-bis(trifluoromethyl)phenyl]borate, tetrakis[3,5-bis(tert-butyl)phenyl]borate, and tetrakis[(3,5-bis(1,1,1,3,3,3-hexafluoro-2-methoxypropan-2-yl)phenyl)phenyl]borate.

As such, the composition comprises an alkyltin-oxo cage cation having tetrakis(pentafluorophenyl) borate counterions, tetrakis[3,5-bis(trifluoromethyl)phenyl]borate counterions, tetrakis[3,5-bis(tert-butyl)phenyl]borate counterions, or tetrakis[(3,5-bis(1,1,1,3,3,3-hexafluoro-2-methoxypropan-2-yl)phenyl)phenyl]borate counterions.

The alkyltin-oxo cage cation may be an n-butyltin-oxo cage dication, preferably having the formula [(BuSn)₁₂O₁₄(OH)₆]²⁺.

The substrate may be any substrate which is masked with a resist in a lithographic process. For example, the substrate may comprise silicon. The substrate may be a silicon wafer.

According to a fourth aspect of the present invention, there is provided a lithographic method comprising the steps of: a) providing a resist composition comprising an alkyltin-oxo cage having a counterion selected from the group consisting of: tetrakis(pentafluorophenyl) borate, tetrakis[3,5-bis(trifluoromethyl)phenyl]borate, tetrakis[3,5-bis(tert-butyl)phenyl]borate, and tetrakis[(3,5-bis(1,1,1,3,3,3-hexafluoro-2-methoxypropan-2-yl)phenyl)phenyl]borate; b) exposing the resist composition to a patterned radiation beam or an electron beam to form a pattern in the resist composition; and c) developing the resist to form a circuit pattern.

The alkyltin-oxo cage may be an n-butyltin-oxo cage dication, preferably having the formula [(BuSn)₁₂O₁₄(OH)₆]²⁺.The resist may be developed in a solvent. The solvent may comprise alkylbenzene. The alkylbenzene may be selected from ethylbenzene, methylbenzene, and xylene. The solvent may also a non-aromatic hydrocarbon solvent, for example a low molecular weight aliphatic hydrocarbon such as petroleum ether (40-60 °C boiling point), n-alkanes, or isoalkanes.

The resist composition may be exposed to a patterned radiation beam or an electron beam at a dose of around 8 to around 100 mJ cm⁻², preferably from around 10 to around 60 mJ cm⁻². The dose may be up to around 50 mJ cm⁻², 40 mJ cm⁻², up to around 30 mJ cm⁻², or up to around 25 mJ cm⁻².
Due to the high absorption cross section and sensitivity of the compounds described herein, the resist composition can be patterned at relatively low doses. This is advantageous for throughput of a lithographic apparatus.

The resist composition may be provided by spin coating. Spin coating allows for careful control of the thickness of the resist layer.

The patterned radiation beam may be an EUV radiation beam. This allows for the creation of very small patterns within the resist material, which is advantageous during production of integrated circuits. The patterned radiation beam may comprise radiation having a shorter wavelength than EUV.

In chemically amplified resists (CARs), there is substantial chemical noise which results from the mechanism of action of CARs, mainly from acid and quencher noise. The chemical noise causes roughness and limits the size of the features which can be realised. In particular, the noise is inherent in the mechanism of action of CARs since the mechanism is based on acid groups generated from the PAGs which diffuse through the resist before reacting. The acid groups generated from the photo-acid generators (PAGs) of the chemically amplified resists diffuse within the resist to outside the portion of the resist which has been exposed to the electromagnetic radiation and this contributes to blurring. As such, the ultimate location where the reaction causing a change in the solubility of the resist in a developer takes place is not only limited to the area on which the EUV photons (or any other electromagnetic radiation being used) are incident on the resist. Furthermore, the acids and quenchers of the resist are randomly dispersed. In small features, the absolute number of acids and quenchers is limited, which results in Poisson noise. In addition, with CAR systems, pattern collapse becomes an issue at low critical dimensions as a result of the blur caused by the nature of the CAR system. Furthermore, with the size of the features desired to be produced shrinking, alternative resist platforms are required. In cases where high doses are required, it is necessary for the resist to be exposed to the electromagnetic radiation source for a longer period of time. As such, the number of chips which can be produced by a single machine in a given time period is reduced. The use of the alkyltin-oxo cage with tetrakis (pentafluorophenyl) borate counterions, tetrakis[3,5-bis(trifluoromethyl)phenyl]borate counterions, tetrakis[3,5-bis(tert-butyl)phenyl]borate counterions, or tetrakis[(3,5-bis(1,1,1,3,3,3-hexafluoro-2-methoxypropan-2-yl)phenyl)phenyl]borate counterions, particularly (BuSn)₁₂O₁₄(OH)₆ (B(C₆F₅)₄)₂, (BuSn)₁₂O₁₄(OH)₆ (B((Ph(CF₃)₂)₄)₂, (BuSn)₁₂O₁₄(OH)₆ (B(Ph(tert-Bu)₂)₄)₂, and (BuSn)₁₂O₁₄(OH)₆(B(Ph(C(CF₃)₂(OMe))₂)₄)₂, addresses at least some of the issues with existing resists.

The features described in respect of one aspect of the present invention also apply to other aspects of the present invention and features of each of the aspects of the present invention may be combined with features described in respect of other aspects of the present invention. All such combinations of subject matter are explicitly considered and disclosed.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source which may be used to irradiate the resist compositions of the present invention;
- Figure 2a is a graph showing the remaining thickness of a resist comprising the resist composition according to the present invention versus dose;
- Figure 2b is a schematic depiction of the structure of an exemplary bis(tetrakis(pentafluorophenyl)borate) alkyltin-oxo cage;
- Figure 3a is a graph showing the remaining thickness of a resist comprising a prior art resist composition; and
- Figure 3b is a schematic depiction of the structure of an existing alkyltin-oxo cage comprising hydroxide counterions.
- Figure 4 is a graph showing the Mass spectra of [(BuSn)₁₂O₁₄(OH)₆]²⁺ with tetrakis(pentafluorophenyl)borate counterions.
- Figures 5a and 5b are graphs showing the ¹H NMR spectra of [(BuSn)₁₂O₁₄(OH)₆]²⁺ with OH⁻and tetrakis(pentafluorophenyl)borate counterions.

### DETAILED DESCRIPTION

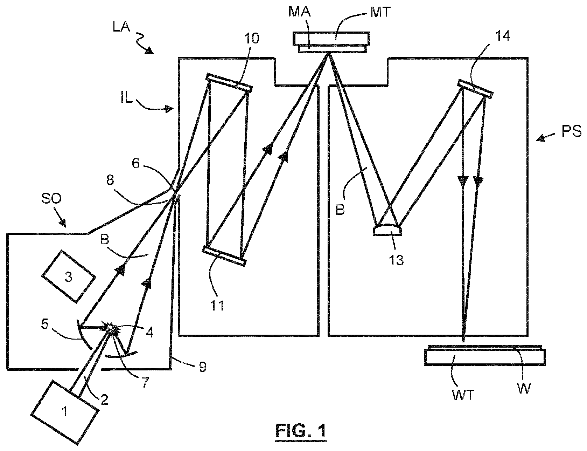

Figure 1 shows a lithographic system which may be used to irradiate the resist compositions of the present invention. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. A layer of the resist composition according to an embodiment of the present invention is provided on the substrate W. The illumination system IL is configured to condition the radiation beam B before it is incident upon the patterning device MA. The projection system is configured to project the radiation beam B (now patterned by the mask MA) onto the substrate W. The substrate W may include previously formed patterns. Where this is the case, the lithographic apparatus aligns the patterned radiation beam B with a pattern previously formed on the substrate W.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type which may be referred to as a laser produced plasma (LPP) source). A laser 1, which may for example be a CO₂ laser, is arranged to deposit energy via a laser beam 2 into a fuel, such as tin (Sn) which is provided from a fuel emitter 3. Although tin is referred to in the following description, any suitable fuel may be used. The fuel may for example be in liquid form, and may for example be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a plasma 7 at the plasma formation region 4. Radiation, including EUV radiation, is emitted from the plasma 7 during de-excitation and recombination of ions of the plasma.

The EUV radiation is collected and focused by a near normal incidence radiation collector 5 (sometimes referred to more generally as a normal incidence radiation collector). The collector 5 may have a multilayer structure which is arranged to reflect EUV radiation (e.g. EUV radiation having a desired wavelength such as 13.5 nm). The collector 5 may have an elliptical configuration, having two ellipse focal points. A first focal point may be at the plasma formation region 4, and a second focal point may be at an intermediate focus 6, as discussed below.

The laser 1 may be separated from the radiation source SO. Where this is the case, the laser beam 2 may be passed from the laser 1 to the radiation source SO with the aid of a beam delivery system (not shown) comprising, for example, suitable directing mirrors and/or a beam expander, and/or other optics. The laser 1 and the radiation source SO may together be considered to be a radiation system.

Radiation that is reflected by the collector 5 forms a radiation beam B. The radiation beam B is focused at point 6 to form an image of the plasma formation region 4, which acts as a virtual radiation source for the illumination system IL. The point 6 at which the radiation beam B is focused may be referred to as the intermediate focus. The radiation source SO is arranged such that the intermediate focus 6 is located at or near to an opening 8 in an enclosing structure 9 of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system comprises a plurality of mirrors which are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors in Figure 1, the projection system may include any number of mirrors (e.g. six mirrors).

The radiation sources SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

The term "EUV radiation" may be considered to encompass electromagnetic radiation having a wavelength within the range of 4-20 nm, for example within the range of 13-14 nm. EUV radiation may have a wavelength of less than 10 nm, for example within the range of 4-10 nm such as 6.7 nm or 6.8 nm.

Although Figure 1 depicts the radiation source SO as a laser produced plasma LPP source, any suitable source may be used to generate EUV radiation. For example, EUV emitting plasma may be produced by using an electrical discharge to convert fuel (e.g. tin) to a plasma state. A radiation source of this type may be referred to as a discharge produced plasma (DPP) source. The electrical discharge may be generated by a power supply which may form part of the radiation source or may be a separate entity that is connected via an electrical connection to the radiation source SO.

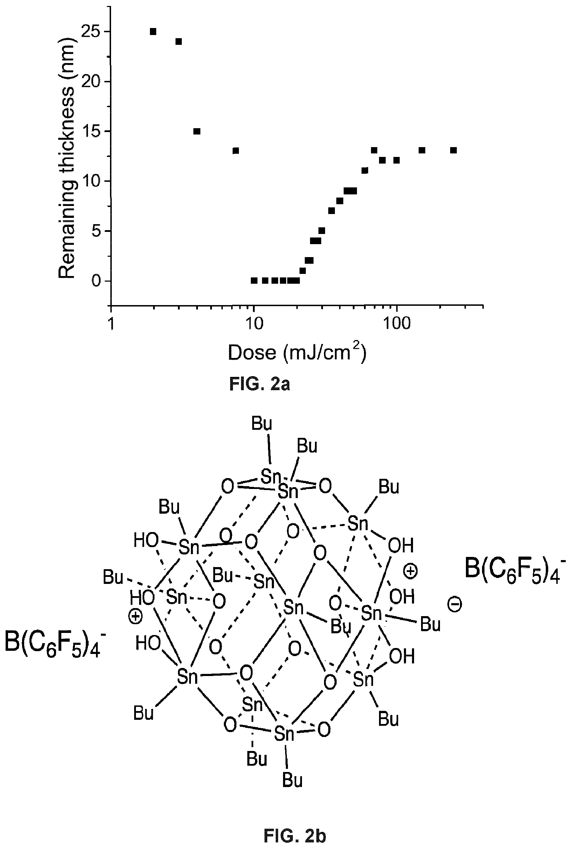

Figure 2a is a graph showing the thickness of a resist comprising the resist composition according to the present invention versus dose. Figure 2b depicts the structure of the bis(tetrakis(pentafluorophenyl)borate) alkyltin-oxo cage according to aspects of the present invention. The resist was spin coated from fluorobenzene and developed with toluene. As can be clearly seen from the graph, at doses between around 10 and 25 mJ cm⁻² the thickness of the resist after developing was measured as zero or very close to zero. At lower doses than this, the thickness of the resist was between 15 and 25 nm. As such, the resist composition according to the present invention displays unexpected positive tone characteristics at these low doses. At higher doses, the remaining thickness is greater than zero, but remains lower than is observed at doses below around 10 mJ cm⁻², even up to doses of 100 mJ cm⁻².

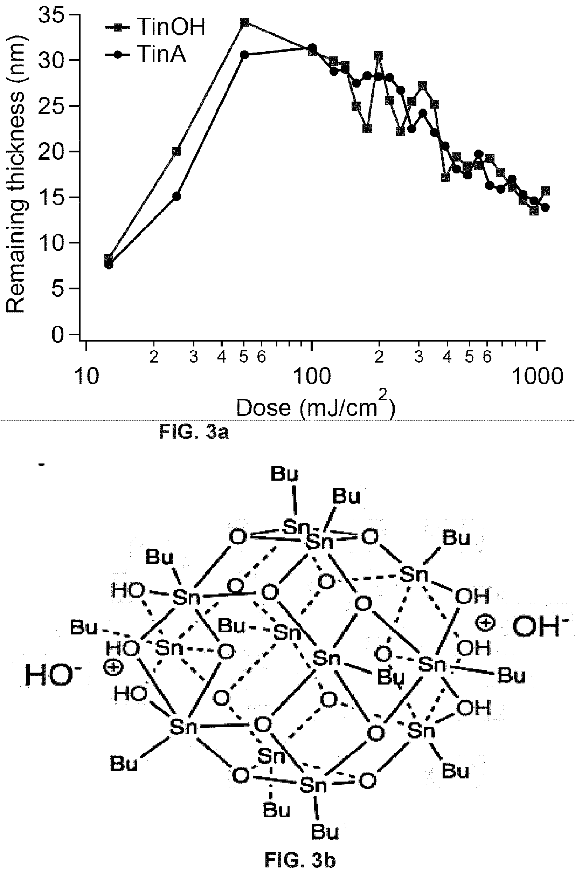

Figure 3a is a graph showing the remaining thickness of a resist comprising a prior art resist composition. In Figure 3a TinOH refers to the tin-oxo cage having hydroxide counterions and TinA refers to the tin-oxo cage having AcOH counterions. Figure 3b is a schematic depiction of the structure of an existing alkyltin-oxo cage comprising hydroxide counterions. The resist was spin-coated from toluene and developed with isopropanol and water. This comparative example depicts how at doses of around 11 to 50 mJ cm⁻², this resist composition becomes less soluble and therefore acts as a negative tone resist. This continues at even higher doses of around 100 mJ cm⁻². This is the case where the counterions are hydroxide ions or AcOH ions. Although at high doses, the remaining thickness of the resist begins to decrease, such doses are extremely high and are unsuitable for use in a commercial lithographic method.

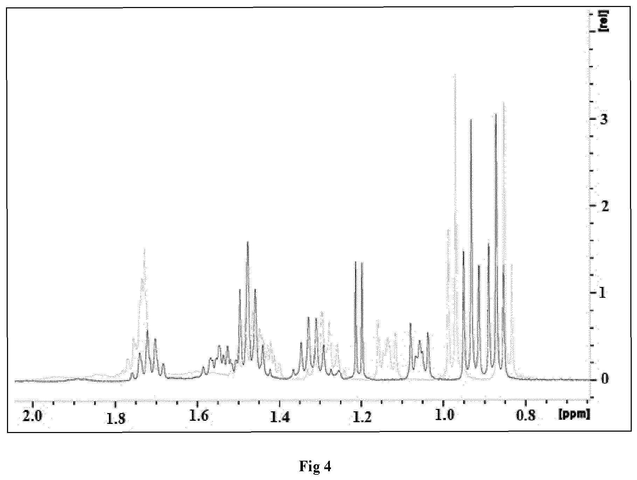

Figure 4 is a graph showing the ¹H NMR spectra of [(BuSn)₁₂O₁₄(OH)₆]²⁺ with tetrakis(pentafluorophenyl)borate counterions measured at 400 MHz ¹H NMR spectra in CDCl₃ of alkyltin-oxo cage having hydroxide (black) or tetrakis(pentafluorophenyl)borate (grey) counteranion. This graph shows the difference in chemical shifts of the protons of the butyl groups between [(BuSn)₁₂O₁₄(OH)₆]²⁺ with tetrakis(pentafluorophenyl)borate counterions and with hydroxide counterions indicating the expected changes due to the exchange of the anions. The x axis is in part per million (ppm) and the y axis in relative intensities (rel).

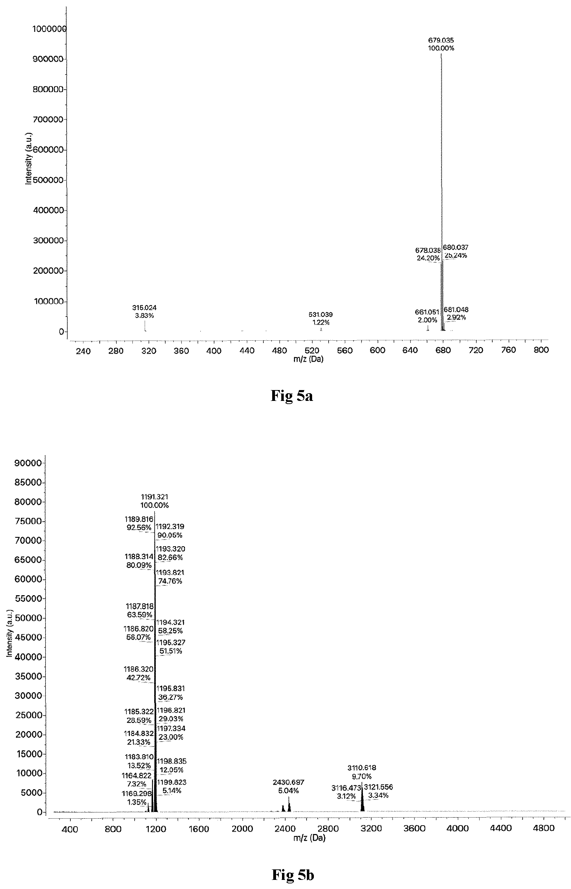

Figures 5a and 5b are graphs showing the mass spectra of [(BuSn)₁₂O₁₄(OH)₆]²⁺ with OH⁻and tetrakis(pentafluorophenyl)borate counterions. Figure 5a shows the Negative Ion Electrospray ionization (ESI) mass spectrum of alkyltin-oxo cage with tetrakis(pentafluorophenyl) borate counteranion, while Figure 5b shows the Positive Ion Electrospray ionization (ESI) mass spectrum of alkyltin-oxo cage with tetrakis(pentafluorophenyl) borate counteranion. These graphs show the atomic mass over charge of both negative (5a) and positive (5b) ions, indicating correct atomic mass for both the anions and the cations of the photoresist material. The x axis is in atomic mass over charge (m/z) while the y axis is intensity in arbitrary units.

### EXAMPLE

The compounds described herein may be synthesized by any suitable synthetic route. For example, the bis(tetrakis(pentafluorophenyl)borate) tin-oxo-cage can be synthesized from the dihydroxide tin-oxo cage via anion exchange. The dihydroxide tin cage (0.1 mmol; 250 mg) may be sonicated in 4 mL of toluene for ten minutes. A 10 mL aqueous solution of hydrogen tetrakis(pentafluorophenyl)borate (0.2 mmol; 136 mg) may be added. The resulting mixture may then be sonicated for an hour and left at 20°C for an additional hour. The resulting slurry may be filtered (P4 grit) and washed with 4 x 10 mL aliquots of water to yield an off-white powder.

The hydrogen tetrakis(pentafluorophenyl)borate may be synthesized using an ion-exchange of sodium tetrakis(pentafluorophenyl)borate and HCl. 20 mL of Na-B(C₆F₅)₄ aqueous solution (10% w/w) may be heated to 40°C and 0.3 mL of HCl (37% w/w) may be added under stirring at 40°C for 30 minutes. The solution may be allowed to cool to room temperature and the product extracted with 5 additions of 20 mL of diethyl ether, which is subsequently evaporated at 35°C. The crystals may be collected via filtration.

The descriptions above are intended to be illustrative and not limiting. Thus, it will be apparent to one skilled in the art that modifications may be made to the invention as described without departing from the scope of the claims.

The present invention relies upon the provision an alkyltin-oxo cage having large, non-nucleophilic counterions, such as tetrakis(pentafluorophenyl)borate) counterions, which unexpectedly provide positive tone characteristics at low doses, particularly between around 10 and 25 mJ cm⁻², but also up to higher doses. This makes compositions comprising such compounds eminently suitable for the fabrication of integrated circuits. The present invention provides useful alternative positive tone resist compositions which are sensitive to low doses of radiation.

## Claims

1. A resist composition for use in the fabrication of integrated circuits, wherein the resist composition comprises an alkyltin-oxo cage having a counterion selected from tetrakis(pentafluorophenyl) borate, tetrakis[3,5-bis(trifluoromethyl)phenyl]borate, tetrakis[3,5-bis(tert-butyl)phenyl]borate, and tetrakis[(3,5-bis(1,1,1,3,3,3-hexafluoro-2-methoxypropan-2-yl)phenyl)phenyl]borate.

2. The resist composition according to Claim 1, wherein the alkyltin-oxo cage cation has the formula [(BuSn)₁₂O₁₄(OH)₆]²⁺.

3. The resist composition according to any preceding claim, wherein the resist is a positive tone resist.

4. The resist composition according to any preceding claim, further comprising a solvent, optionally wherein the solvent is an alcohol or a fluorinated hydrocarbon.

5. The use of an alkyltin-oxo cage, preferably an n-butyltin-oxo cage, having a counterion selected from the group consisting of: tetrakis(pentafluorophenyl) borate, tetrakis[3,5-bis(trifluoromethyl)phenyl]borate, tetrakis[3,5-bis(tert-butyl)phenyl]borate, and tetrakis[(3,5-bis(1,1,1,3,3,3-hexafluoro-2-methoxypropan-2-yl)phenyl)phenyl]borate, in a resist composition.

6. The use according to claim 5, wherein the n-butyltin-oxo cage cation has the formula [(BuSn)₁₂O₁₄(OH)₆]²⁺.

7. A substrate comprising a coating on at least one surface wherein said coating is a composition according to claim 1.

8. The substrate according to claim 7, wherein the alkyltin-oxo cage cation is an n-butyltin-oxo cage dication, preferably having the formula [(BuSn)₁₂O₁₄(OH)₆]²⁺.

9. A lithographic method comprising the steps of:
a) providing a resist composition comprising an alkyltin-oxo cage having a counterion selected from the group consisting of: tetrakis(pentafluorophenyl) borate, tetrakis[3,5-bis(trifluoromethyl)phenyl]borate, tetrakis[3,5-bis(tert-butyl)phenyl]borate, and tetrakis[(3,5-bis(1,1,1,3,3,3-hexafluoro-2-methoxypropan-2-yl)phenyl)phenyl]borate;
b) exposing the resist composition to a patterned radiation beam or an electron beam to form a pattern in the resist composition; and
c) developing the resist to form a circuit pattern.

10. The lithographic method according to claim 9, wherein the alkyltin-oxo cage is an n-butyltin-oxo cage dication, preferably having the formula [(BuSn)₁₂O₁₄(OH)₆]²⁺.

11. The lithographic method according to claim 9 or claim 10, wherein the resist is developed in a solvent, optionally wherein the solvent comprises alkylbenzene, optionally wherein the alkylbenzene is selected from ethylbenzene, methylbenzene, and xylene.

12. The lithographic method according to any of claims 9 to 11, wherein the resist composition is exposed to a patterned radiation beam or an electron beam at a dose of around 8 to around 100 mJ cm⁻², preferably from around 10 to around 60 mJ cm⁻².

13. The lithographic method according to any of claims 9 to 12, wherein the resist composition is provided via spin coating.

14. The lithographic method according to any of claims 9 to 13, wherein the patterned radiation beam is an EUV radiation beam.

## Patentansprüche

1. Eine Resistzusammensetzung zur Verwendung bei der Herstellung integrierter Schaltungen, wobei die Resistzusammensetzung einen Alkylzinn-Sauerstoff-Käfig beinhaltet, der ein Gegenion aufweist, das aus Folgendem ausgewählt ist: Tetrakis(pentafluorphenyl)borat, Tetrakis[3,5-bis(trifluormethyl)phenyl]borat, Tetrakis[3,5-bis(tert-butyl)phenyl]borat und Tetrakis[(3,5-bis(1,1,1,3,3,3-hexafluor-2-methoxypropan-2-yl)phenyl)phenyl]borat.

2. Resistzusammensetzung gemäß Anspruch 1, wobei das Alkylzinn-Sauerstoff-Käfig-Kation die Formel [(BuSn)₁₂O₁₄(OH)₆]²⁺ aufweist.

3. Resistzusammensetzung gemäß einem der vorhergehenden Ansprüche, wobei der Resist ein Positivresist ist.

4. Resistzusammensetzung gemäß einem der vorhergehenden Ansprüche, ferner beinhaltend ein Lösungsmittel, wobei das Lösungsmittel optional ein Alkohol oder ein fluorierter Kohlenwasserstoff ist.

5. Die Verwendung eines Alkylzinn-Sauerstoff-Käfigs, vorzugsweise eines n-Butylzinn-Sauerstoff-Käfigs, der ein Gegenion aufweist, das aus der Gruppe ausgewählt ist, die aus Folgendem besteht: Tetrakis(pentafluorphenyl)borat, Tetrakis[3,5-bis(trifluormethyl)phenyl]borat, Tetrakis[3,5-bis(tert-butyl)phenyl]borat und Tetrakis[(3,5-bis(1,1,1,3,3,3-hexafluor-2-methoxypropan-2-yl)phenyl)phenyl]borat, in einer Resistzusammensetzung.

6. Verwendung gemäß Anspruch 5, wobei das n-Butylzinn-Sauerstoff-Käfig-Kation die Formel [(BuSn)₁₂O₁₄(OH)₆]²⁺ aufweist.

7. Ein Substrat, beinhaltend eine Beschichtung auf mindestens einer Oberfläche, wobei die Beschichtung eine Zusammensetzung gemäß Anspruch 1 ist.

8. Substrat gemäß Anspruch 7, wobei das Alkylzinn-Sauerstoff-Käfig-Kation ein n-Butylzinn-Sauerstoff-Käfig-Dikation ist, das vorzugsweise die Formel [(BuSn)₁₂O₁₄(OH)₆]²⁺ aufweist.

9. Ein lithographisches Verfahren, beinhaltend die folgenden Schritte:
a) Bereitstellen einer Resistzusammensetzung, die einen Alkylzinn-Sauerstoff-Käfig beinhaltet, der ein Gegenion aufweist, das aus der Gruppe ausgewählt ist, die aus Folgendem besteht: Tetrakis(pentafluorphenyl)borat, Tetrakis[3,5-bis(trifluormethyl)phenyl]borat, Tetrakis[3,5-bis(tert-butyl)phenyl]borat und Tetrakis[(3,5-bis(1,1,1,3,3,3-hexafluor-2-methoxypropan-2-yl)phenyl)phenyl]borat;
b) Belichten der Resistzusammensetzung mit einem gemusterten Strahlungsstrahl oder einem Elektronenstrahl, um ein Muster in der Resistzusammensetzung zu bilden; und
c) Entwickeln des Resists, um ein Schaltkreismuster zu bilden.

10. Lithographisches Verfahren gemäß Anspruch 9, wobei der Alkylzinn-Sauerstoff-Käfig ein n-Butylzinn-Sauerstoff-Käfig-Dikation ist, das vorzugsweise die Formel [(BuSn)₁₂O₁₄(OH)₆]²⁺ aufweist.

11. Lithographisches Verfahren gemäß Anspruch 9 oder Anspruch 10, wobei der Resist in einem Lösungsmittel entwickelt wird, wobei das Lösungsmittel optional Alkylbenzen beinhaltet, wobei das Alkylbenzen optional aus Ethylbenzen, Methylbenzen und Xylen ausgewählt ist.

12. Lithographisches Verfahren gemäß einem der Ansprüche 9 bis 11, wobei die Resistzusammensetzung mit einem gemusterten Strahlungsstrahl oder einem Elektronenstrahl mit einer Dosis von etwa 8 bis etwa 100 mJ cm⁻², vorzugsweise von etwa 10 bis etwa 60 mJ cm⁻² belichtet wird.

13. Lithographisches Verfahren gemäß einem der Ansprüche 9 bis 12, wobei die Resistzusammensetzung mittels Rotationsbeschichtung bereitgestellt wird.

14. Lithographisches Verfahren gemäß einem der Ansprüche 9 bis 13, wobei der gemusterte Strahlungsstrahl ein EUV-Strahlungsstrahl ist.

## Revendications

1. Une composition de réserve pour son utilisation dans la fabrication de circuits intégrés, où la composition de réserve comprend une cage oxo-alkylétain ayant un contre-ion sélectionné parmi le tétrakis(pentafluorophényl)borate, le tétrakis[3,5-bis(trifluorométhyl)phényl]borate, le tétrakis[3,5-bis(tert-butyl)phényl]borate, et le tétrakis[(3,5-bis(1,1,1,3,3,3-hexafIuoro-2-méthoxypropan-2-yl)phényl)phényl]borate.

2. La composition de réserve selon la revendication 1, où le cation de cage oxo-alkylétain a la formule [(BuSn)₁₂O₁₄(OH)₆]²⁺.

3. La composition de réserve selon n'importe quelle revendication précédente, où la réserve est une réserve de tonalité positive.

4. La composition de réserve selon n'importe quelle revendication précédente, comprenant en sus un solvant, facultativement où le solvant est un alcool ou un hydrocarbure fluoré.

5. L'utilisation d'une cage oxo-alkylétain, préférablement d'une cage oxo-n-butylétain, ayant un contre-ion sélectionné dans le groupe constitué : du tétrakis(pentafluorophényl)borate, du tétrakis[3,5-bis(trifluorométhyl)phényl]borate, du tétrakis[3,5-bis(tert-butyl)phényl]borate, et du tétrakis[(3,5-bis(1,1,1,3,3,3-hexafIuoro-2-méthoxypropan-2-yl)ρhényl)phényl]borate, dans une composition de réserve.

6. L'utilisation selon la revendication 5, où le cation de cage oxo-n-butylétain a la formule [(BuSn)₁₂O₁₄(OH)₆]²⁺.

7. Un substrat comprenant un revêtement sur au moins une surface où ledit revêtement est une composition selon la revendication 1.

8. Le substrat selon la revendication 7, où le cation de cage oxo-alkylétain est un dication de cage oxo-n-butylétain, préférablement ayant la formule [(BuSn)₁₂O₁₄(OH)₆]²⁺.

9. Un procédé lithographique comprenant les étapes consistant :
a) à fournir une composition de réserve comprenant une cage oxo-alkylétain ayant un contre-ion sélectionné dans le groupe constitué : du tétrakis(pentafluorophényl)borate, du tétrakis[3,5-bis(trifluorométhyl)phényl]borate, du tétrakis[3,5-bis(tert-butyl)phényl]borate, et du tétrakis[(3,5-bis(1,1,1,3,3,3-hexafluoro-2-méthoxypropan-2-yl)phényl)phényl]borate ;
b) à exposer la composition de réserve à un faisceau de rayonnement à motif ou un faisceau d'électrons afin de former un motif dans la composition de réserve ; et
c) à développer la réserve afin de former un motif de circuit.

10. Le procédé lithographique selon la revendication 9, où la cage oxo-alkylétain est un dication de cage oxo-n-butylétain, préférablement ayant la formule [(BuSn)₁₂O₁₄(OH)₆]²⁺.

11. Le procédé lithographique selon la revendication 9 ou la revendication 10, où la réserve est développée dans un solvant, facultativement où le solvant comprend de l'alkylbenzène, facultativement où l'alkylbenzène est sélectionné parmi l'éthylbenzène, le méthylbenzène, et le xylène.

12. Le procédé lithographique selon n'importe lesquelles des revendications 9 à 11, où la composition de réserve est exposée à un faisceau de rayonnement à motif ou un faisceau d'électrons à une dose d'environ 8 à environ 100 mJ cm⁻², préférablement d'environ 10 à environ 60 mJ cm⁻².

13. Le procédé lithographique selon n'importe lesquelles des revendications 9 à 12, où la composition de réserve est fournie par dépôt à la tournette.

14. Le procédé lithographique selon n'importe lesquelles des revendications 9 à 13, où le faisceau de rayonnement à motif est un faisceau de rayonnement EUV.
